# EUROPEAN PATENT SPECIFICATION

(11) **EP 2 148 440 B1**
(45) Date of publication and mention of the grant of the patent: **31.05.2017**
(21) Application number: 09166130.6
(22) Date of filing: 22.07.2009
(51) Int. Cl.: H03K 17/18, G05F 1/12

(54) **Driving group and method for an electric load supplied through a conventional-type civil electric system**
Antriebsgruppe und Verfahren für eine elektrische Last, die von einem herkömmlichen öffentlichen Stromsystem geliefert wird
Groupe de commande et procédé pour charge électrique alimenté via un système électrique public de type classique

(30) Priority: 23.07.2008 IT MI20081337
(43) Date of publication of application: 27.01.2010
(73) Proprietor: Bticino S.p.A., 20154 Milano (IT)
(72) Inventor: Santini, Ernesto, 28060, SOZZAGO (Novara) (IT)
(74) Representative: Bonatto, Marco

(56) References cited:
- EP-A- 1 650 870
- WO-A-2006/133152
- WO-A-2007/023414
- US-A1- 2005 253 533
- US-A1- 2007 126 289

## Description

The present invention refers to a driving group and method for a load supplied through a conventional-type civil electric system.

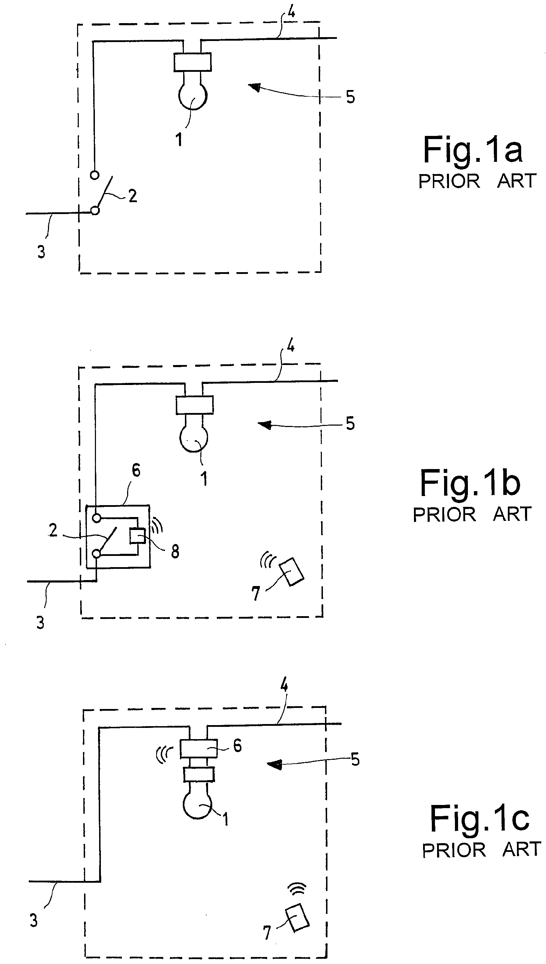

In civil electric systems in existence today, schematized as an example in figure 1a, the power supply of the loads 1, like for example, one or more light sources, is driven through conventional manual switching means 2 suitable for opening or closing the connection between the electric conductor of the phase 3 of the electric system 5 and the load 1.

For the purpose of supplying it, the second pole of the load 1 is permanently connected to the electric conductor of the neutral 4 of the electric system 5. Conventional manual switching means 2, like for example a switch or a diverter, are provided with a manual control interface, like for example, a button.

In order to equip pre-existing civil electric systems with control interfaces able to be driven wirelessly, for example via radio, it is known to replace the manual switches and/or diverters 2 with suitable driving devices 6, able to be controlled both manually and via radio.

For such a purpose, such devices 6 comprise both a manual interface and, in addition, a radio receiver 8 suitable for receiving the signals of a suitable radio transmitter 7 which can be of the movable type, like a remote control, or fixedly connected within the receptive field of the receiver 8.

The receiver 8 is connected to suitable control means (not illustrated) that are able to activate the switching means 2 of the state of the load 1 when there is a radio control in input.

In order for it to operate, the control logic of the driving devices 6 needs a constant power supply. Therefore, as shown in figure 1b, in the case in which the driving device 6 is installed instead of the conventional manual interfaces which, in pre-existing systems, are reached by just the electric conductor of the phase 3 of the electric system 5, it is necessary to foresee complex and bulky additional circuit elements which make it possible to constantly take the supply from the load 1, also when the load is turned off.

For example, if the load 1 is driven in current, it is necessary to use a transformer which has a substantial bulk or a shunt resistance associated with a suitable heat sink.

Otherwise, if the load 1 is driven in voltage, it is necessary to constantly make a small current circulate through the load, even when it is turned off, thus obtaining substantial energy consumption and a rapid wearing of the load.

Therefore, it is preferred to move the driving device 6 near to the load 1, as illustrated in figure 1c.

In such a way, the device can also be directly connected to the electric conductor of the neutral 4 of the electric system 5 and thus directly supplied with power without needing additional and suitable circuits to source the power supply.

However, in this case, also the manual control interface would be near to the load 1 and therefore would not always be easy to reach, in particular in the case in which the load is a light source on the ceiling.

The functionality of the manual control interface is thus lost. Document US 2007/126289 describes an electronic switching device for turning on/off an electrical device comprising a first and a second switching means for the manual and/or remote load control, respectively. The manual load control is achieved by a manual control signal of voltage variation detected by a monitoring circuit coupled to the second switching means.

The purpose of the present invention is that of avoiding the aforementioned drawbacks and in particular that of making a driving group for a load which offers the driving functionality of the load wirelessly, while still maintaining the possibility of manual driving and without needing suitable power supply circuitry.

A further purpose of the present invention is that of making a driving method for an electric load which allows both manual commands and wireless commands, for the switching of the state of the light source, to be managed.

These and other purposes, according to the present invention are achieved by making a driving group and method for a load as outlined in the independent claims. Further characteristics of the driving group and method are object of the dependent claims.

The characteristics and advantages of a driving group and method for a load according to the present invention shall become clearer from the following description, given as an example and not for limiting purposes, referring to the attached schematic drawings, in which:
- figure 1a is a schematic representation of a conventional type electric system using a manual control switch and/or diverter;
- figure 1b is a schematic view of a known type electric system using a driving device arranged at a distance from the load;
- figure 1c is a schematic representation of a known type electric system using a driving device arranged at the load;
- figure 2a is a schematic representation of a first embodiment of the driving group for a load according to the present invention in a first installation variant;
- figure 2b is a schematic representation of the first embodiment of the driving group for a load according to the present invention in a second installation variant;
- figure 3 is a block diagram of the wireless driving device for a load belonging to the driving group according to the present invention;
- figure 4 is a graph representing the manual activation signal of the driving groups of figures 2a and 2b;
- figure 5a is a schematic representation of a second embodiment of the driving group for a load according to the present invention in a first installation variant;
- figure 5b is a schematic representation of the second embodiment of the driving group for a load according to the present invention in a second installation variant;
- figure 6a is a graph representing the manual activation signal of the driving groups of figures 5a and 5b;
- figure 6b is a graph representing the power supply supplied to the loads after the activation signal illustrated in figure 6a;

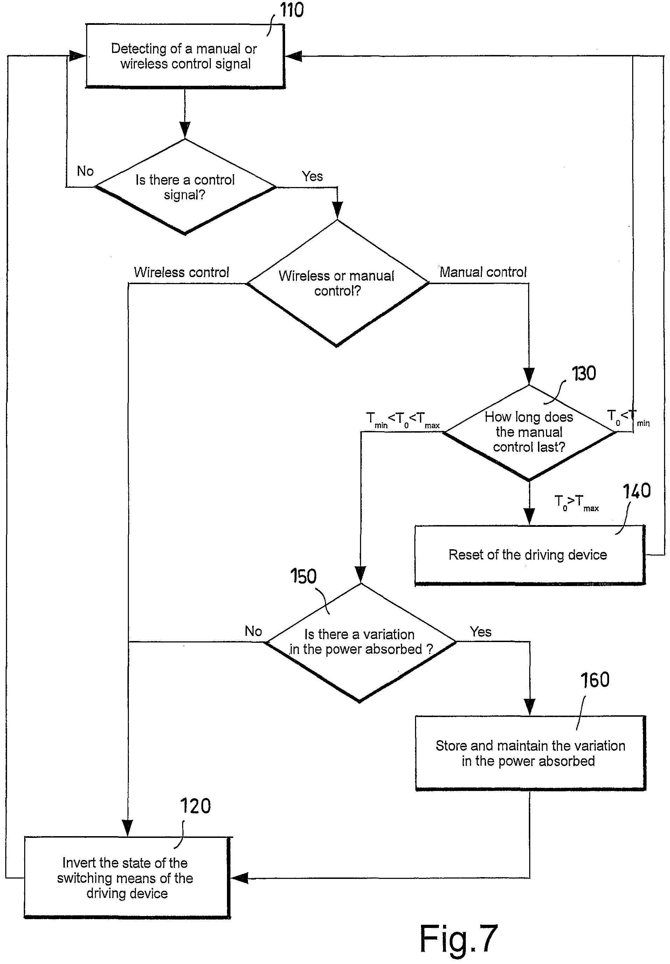

- figure 7 is a block diagram of the driving method according to the present invention.

First of all, it should be noted, that even if in the following reference will be specifically made to the driving of a resistive load, such as a light bulb or a general light source, the invention should be considered to cover any load able to be controlled by one or more conventional type switches or diverters.

With reference to the figures, a driving group 10, 21 for electric loads is shown, comprising a wireless driving device 10 for a load 11, connected in series to first switching means 21 of the state of the load 11 preferably arranged distal from the driving device 10 and in particular in a position which can be accessed manually.

According to the present invention, the first switching means 21 comprise a manual control interface which allows a voltage lack signal to be sent.

For such a purpose the first switching means 21 are a switch of the NC (normally closed) type, which opens the connection between an electric conductor 13, 14 of an electric system 15, preferably between the electric conductor of the phase 13, and the driving device 10, for the period it is kept pressed.

The driving device 10 comprises second switching means 12, suitable for opening or closing the connection between an electric conductor 13, 14 of the electric system 15, preferably the electric conductor of the phase 13, and the load 11.

The second switching means 12 are driven to open and close by control means 19.

For such a purpose, the control means 19 receive a signal in input coming from a wireless receiver 18 to which they are connected. Such a receiver 18 in turn receives a control signal sent wirelessly by a respective transmitter 17.

According to the present invention, the control means 19 also receive a signal in input generated by a power supply circuit 20, which has two terminals for the connection to the electric system 15 and specifically, both to the electric conductor of the phase 13, and to the electric conductor of the neutral 14.

In particular, the power supply circuit 20 is able to detect a manual command signal in the form of a voltage lack signal having duration T₀ of between a minimum set value of duration Tₘᵢₙ and a set maximum duration value Tₘₐₓ.

When there is such a voltage lack signal, generated by the opening of the NC switch 21, the control means 19 invert the state of the second switching means 12.

Through the activation of the manual control interface of the first switching means 21 and therefore through the opening of the NC switch 21, it is therefore also possible to manually switch the state of the load 11.

In order to allow the driving device 10 to be able to continue operating even without there being power supplied to it for the duration of the voltage lack signal, a capacitive element (not illustrated) is foreseen, able to keep the power supply circuit 20 supplied for the duration of such a signal.

The size of the capacitive element determines the minimum duration Tₘᵢₙ and the maximum duration Tₘₐₓ of the lack of voltage able to be detected by the control means 19.

The minimum duration Tₘᵢₙ is selected, so as to filter possible noise signals.

Otherwise, if the NC switch 21 is kept open for a longer period than the maximum duration Tₘₐₓ, the wireless driving device 10 resets, bringing in this way, the load 11 into the off-state.

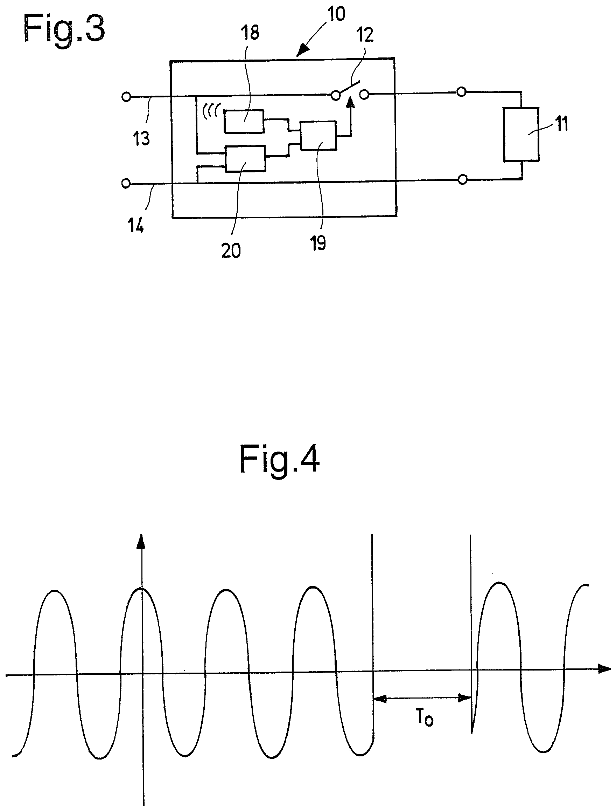

Therefore, as shown in figure 4, in input to the wireless driving device 10, there is always the power supplying phase 13 and a manual control signal is detected in the form of a lack of voltage for the period T₀, in which the NC switch 21 is kept open.

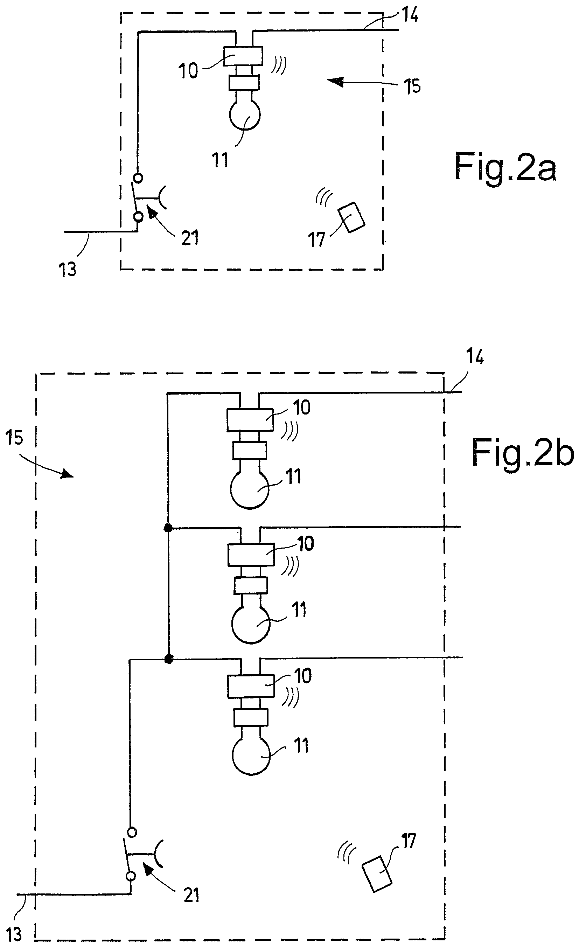

After detecting the lack of voltage, the control means 19 switch the state of the load 11 through the opening, or closing respectively of the second switching means 12. The use of a lack of voltage, namely of a total absence of voltage as the driving signal of the control means 19 of the wireless driving device 10, is particularly advantageous in the case of many loads 11 controlled by the same first switching means 21, as illustrated in figure 2b.

Indeed, in such a case, if the loads 11 are brought to different states through the wireless activation of the respective driving devices 10, the activation of the first switching means 21 for a duration T₀ which is between the minimum duration Tₘᵢₙ and the maximum duration Tₘₐₓ, switches the state of the single loads 11 never allowing, for example, a configuration having all the loads 11 in the off-state.

Thanks to the lack of voltage kept for a longer time than the maximum duration Tₘₐₓ, it is on the other hand possible to completely deprive the wireless driving devices 10 of their power supply, so as to make them reset, aligning in this way, all the loads 11 in the off-state.

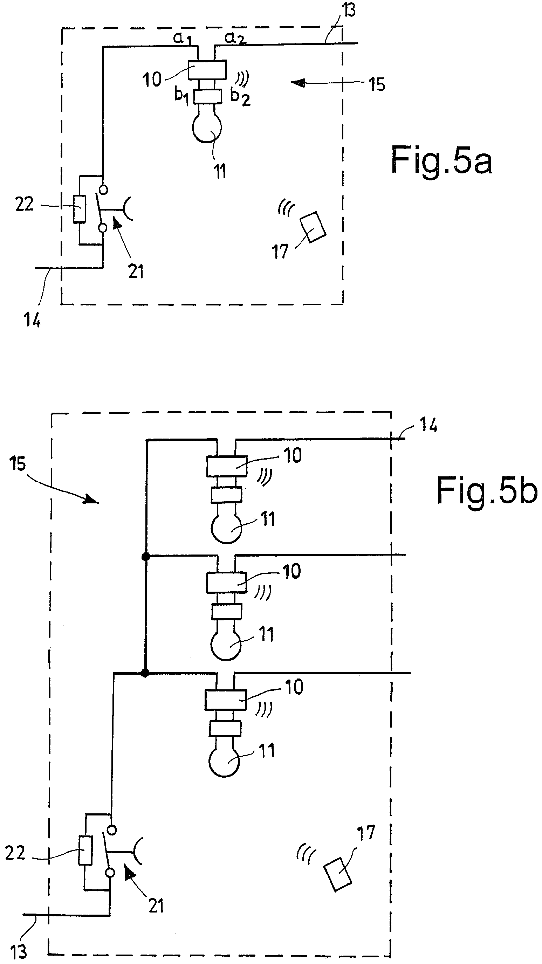

Not least, the use of a lack of voltage as a driving signal of the control means 19 of the wireless driving device 10, allows to implement the first switching means 21 without needing additional elements able to keep a non zero voltage even when such switching means 21 are in the open state, like for example, a capacitor unit positioned parallel to the switching means 21. This allows there to be a substantial saving, both in terms of system complexity, as well as in terms of total costs. In an alternative embodiment shown in figures 5a and 5b, in parallel with the NC switch 21, a dimmer or delayed dimmer 22 is foreseen, able to adjust the amount of power absorbed by the load 11, and therefore, in the case of a light source, the light intensity.

In such a way, by opening the NC switch 21, the dimmer 22 activates with a certain delay T₀, sufficient to allow the control means 19 to detect the lack of voltage and therefore to switch the state of load 11.

Keeping the NC switch 21 open for an additional time T_{D}, during such period T_{D}, it is possible to act upon the dimmer 22 and to modify the power absorbed by the load 11.

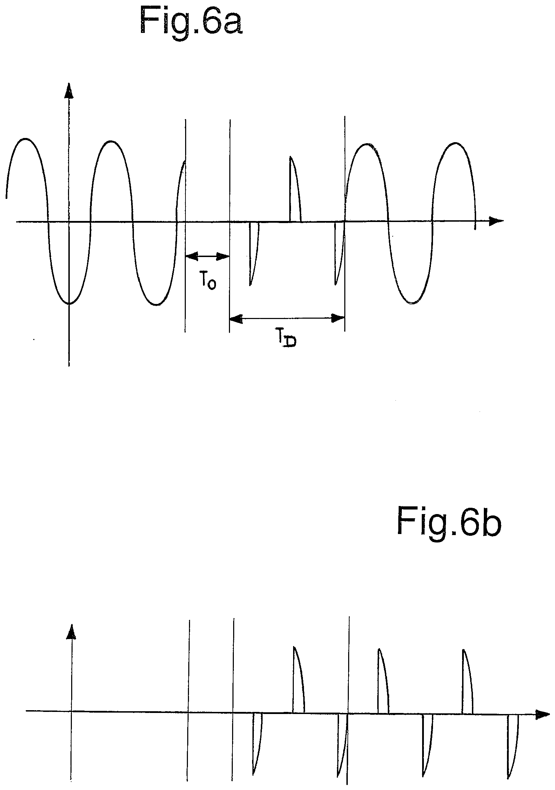

The voltage detected at the terminals a1, a2 in input to the driving device 10, is shown in figure 6a.

After the detection of the lack of voltage, the control means 19, store the variation operated through the dimmer 22, during the additional period T_{D} in which, the NC switch 21 has been kept open, and supply power to the load 11 as illustrated in figure 6b, which represents the voltage at the terminals b1, b2 of the load 11. When the NC switch 21 is closed again, the control means 19 keep the level of power absorbed by the load 11 constant and equal to the value present at the closing of the NC switch 21.

The operation of the group 10, 21 for wireless driving electric loads 11, according to the present invention, is the following.

The control means 19 constantly detect the presence of an input control signal (phase 110) through monitoring of a signal coming from the wireless receiver 18 and of the voltage present in the electric conductor of the phase 13.

When a control signal is received through the wireless receiver 18, sent through the transmitter 17, as well as when a lack of voltage is detected on the electric conductor of the phase 13, the control means 19 drive the switching means 12 to open, or close, respectively thus inverting the state of the load 11 (phase 120).

In particular, when there is a manual control signal, its duration is determined (phase 130). If such duration is shorter than that of a set value Tₘᵢₙ, the manual control is ignored. If, on the other hand, the manual control signal has a longer duration than that of a set maximum value Tₘₐₓ, the driving device resets (phase 140).

Moreover, in the case in which a variation in the power absorbed by the load is detected (phase 150) in input to the control means 19 during a period directly following a lack of voltage having a duration within the set limits Tₘᵢₙ, Tₘₐₓ, the final absorbed power is stored (phase 160) by the control means 19 and the load 11 is then supplied with such a modified power.

From the description made, the characteristics of the driving group and of the respective method, object of the present invention, as well as the relative advantages, should be clear.

Finally, it is clear that the driving group thus conceived can undergo numerous modifications and variants, all covered by the invention; moreover, all the details can be replaced by technically equivalent elements. In practice the materials used as well as the sizes, can be any according to the technical requirements.

## Claims

1. Driving group for an electric load (11) supplied through an electric system (15) comprising a device (10) for wireless driving said load (11) having second switching means (12) for opening and closing the connection between said load (11) and at least one electric conductor (13, 14) of said electric system (15), and with control means (19) connected to a wireless receiver (18) and to a power supply circuit (20) for connection to said electric system (15), said control means (19) driving said second switching means (12) for opening and closing in presence of a wireless control signal coming from said wireless receiver (18) **characterised in that** said device (10) for wireless driving is connected in series to first switching means (21) provided with a manual interface for generating a manual control signal of lack of voltage having a duration (T₀), and **in that** said control means (19) are further adapted to drive said second switching means (12) for opening and closing in presence of said manual control signal of lack of voltage when its duration (T₀) is comprised between a minimum value (Tₘᵢₙ) and a maximum value (Tₘₐₓ), said driving device (10) being reset if said duration (T₀) of said manual control signal of lack of voltage is longer than said maximum value (Tₘₐₓ).

2. Driving group for an electric load (11) according to claim 1 **characterised in that** said first switching means (21) are switches of the normally closed type for opening and closing the connection between said wireless driver device (10) and said at least one electric conductor (13, 14) of said electrical system (15).

3. Driving group for an electric load (11) according to any one of the preceding claims, **characterised in that** said device (10) for wireless driving comprises a capacitive element adapted to keep said power supply circuit (20) supplied for the duration (T₀) of said manual control signal.

4. Driving group for an electric load (11) according to any one of the preceding claims, **characterised in that** said first switching means (21) are connected in parallel to a delayed dimmer (22).

5. Method for driving an electric load (11) supplied through an electric system (15) comprising the steps consisting in detecting (110) the presence of a wireless control signal or a manual control signal entering a device (10) for driving said load (11), and switching (120) the status of said load (11) in case at least one between said wireless control signal and said manual control signal is detected, **characterised in that** said manual control signal is a voltage lack signal having a duration (T₀) comprised between a minimum value (Tₘᵢₙ) and a maximum value (Tₘₐₓ), said driving device (10) being reset if the duration (T₀) of said manual control signal of lack of voltage is longer than said maximum value (Tₘₐₓ).

6. Method for driving an electric load (11) according to claim 5, **characterised in that** it comprises a step consisting in detecting (150) and storing (160) a variation of the power absorbed by said load (11) subsequent to the detection of a manual control signal, and a step consisting in supplying said load with said modified power.

## Patentansprüche

1. Antriebsgruppe für eine elektrische Last (11), die von einem Stromsystem (15) geliefert wird, umfassend eine Einrichtung (10) zum drahtlosen Antreiben der Last (11) mit zweiten Schaltmitteln (12) zum Öffnen und Schließen der Verbindung zwischen der Last (11) und wenigstens einem elektrischen Leiter (13, 14) des elektrischen Systems (15) und mit Steuermitteln (19), die mit einem drahtlosen Empfänger (18) und einer Stromversorgungsschaltung (20) zum Anschluss an das elektrische System (15) verbunden sind, wobei die Steuermittel (19) die zweiten Schaltmittel (12) zum Öffnen und Schließen in Gegenwart eines drahtlosen Schaltsignals antreiben, das von dem drahtlosen Empfänger (18) kommt, **dadurch gekennzeichnet, dass** die Einrichtung (10) zum drahtlosen Antrieb mit ersten Schaltmitteln (21) in Reihe geschaltet ist, die mit einer manuellen Schnittstelle zum Erzeugen eines manuellen Spannungsmangel-Steuersignal mit einer Dauer (To) versehen ist, sowie dadurch, dass die Steuermittel (19) ferner dazu geeignet sind, die zweiten Schaltmittel (12) zum Öffnen und Schließen in Gegenwart des manuellen Spannungsmangel-Steuersignals anzutreiben, wenn seine Dauer (T₀) zwischen einem Mindestwert (Tₘᵢₙ) und einem Höchstwert (Tₘₐₓ) liegt, wobei die Antriebseinrichtung (10) zurückgesetzt wird, wenn die Dauer (To) des manuellen Spannungsmangel-Steuersignals länger als der Höchstwert (Tₘₐₓ) ist.

2. Antriebsgruppe für eine elektrische Last (11) nach Anspruch 1, **dadurch gekennzeichnet, dass** die ersten Schaltmittel (21) Schalter vom normalerweise geschlossenen Typ zum Öffnen und Schließen der Verbindung zwischen der drahtlosen Antriebseinrichtung (10) und dem wenigstens einen elektrischen Leiter (13, 14) des Stromsystems (15) sind.

3. Antriebsgruppe für eine elektrische Last (11), nach einem der vorstehenden Ansprüche, **dadurch gekennzeichnet, dass** die Einrichtung (10) zum drahtlosen Antrieb ein kapazitives Element umfasst, das dazu geeignet ist, die Lieferung der Stromversorgungsschaltung (20) für die Dauer (To) des manuellen Steuersignals aufrechtzuerhalten.

4. Antriebsgruppe für eine elektrische Last (11) nach einem der vorstehenden Ansprüche, **dadurch gekennzeichnet, dass** die ersten Schaltmittel (21) mit einem verzögerten Leistungsregler (22) parallel geschaltet sind.

5. Verfahren zum Antreiben einer elektrischen Last (11), die von einem Stromsystem (15) geliefert wird, umfassend die Schritte bestehend aus dem Erfassen (110) der Gegenwart eines drahtlosen Steuersignals oder eines manuellen Steuersignals, das in einer Einrichtung (10) zum Antreiben der Last (11) eingeht, und aus dem Umschalten (120) des Zustands der Last (11), wenn wenigstens eine zwischen dem drahtlosen Steuersignal und dem manuellen Steuersignal erfasst wird, **dadurch gekennzeichnet, dass** das manuelle Steuersignal ein Spannungsmangel-Steuersignal mit einer Dauer (To) zwischen einem Mindestwert (Tₘᵢₙ) und einem Höchstwert (Tₘₐₓ) ist, wobei die Antriebseinrichtung (10) zurückgesetzt wird, wenn die Dauer (T₀) des manuellen Spannungsmangel-Steuersignals länger als der Höchstwert (Tₘₐₓ) ist.

6. Verfahren zum Antreiben einer elektrischen Last (11) nach Anspruch 5, **dadurch gekennzeichnet, dass** es einen Schritt umfasst, bestehend aus dem Erfassen (150) und Speichern (160) einer Variation der Leistung, die nach dem Erfassen eines manuellen Steuersignals von der Last (11) aufgenommen wird, und einen Schritt bestehend aus dem Versorgen der Last mit der geänderten Leistung.

## Revendications

1. Groupe de commande pour une charge électrique (11) alimentée par le biais d'un système électrique (15) comprenant un dispositif (10) pour commander sans fil ladite charge (11) ayant des deuxièmes moyens de commutation (12) pour l'ouverture et la fermeture de la connexion entre ladite charge (11) et au moins un conducteur électrique (13, 14) dudit système électrique (15), et avec des moyens de commande (19) connectés à un récepteur sans fil (18) et à un circuit d'alimentation électrique (20) pour la connexion audit système électrique (15), lesdits moyens de commande (19) commandant lesdits deuxièmes moyens de commutation (12) pour l'ouverture et la fermeture en présence d'un signal de commande sans fil provenant dudit récepteur sans fil (18), **caractérisé en ce que** ledit dispositif (10) de commande sans fil est connecté en série à des premiers moyens de commutation (21) munis d'une interface manuelle pour générer un signal de commande manuelle d'absence de tension ayant une durée (To), et **en ce que** lesdits moyens de commande (19) sont adaptés en outre pour commander lesdits deuxièmes moyens de commutation (12) pour l'ouverture et la fermeture en présence dudit signal de commande manuelle d'absence de tension quand sa durée (To) est comprise entre une valeur minimale (Tₘᵢₙ) et une valeur maximale (Tₘₐₓ), ledit dispositif de commande (10) étant réinitialisé si ladite durée (T₀) dudit signal de commande manuelle d'absence de tension est plus longue que ladite valeur maximale (Tₘₐₓ).

2. Groupe de commande pour une charge électrique (11) selon la revendication 1, **caractérisé en ce que** lesdits premiers moyens de commutation (21) sont des commutateurs du type normalement fermé pour l'ouverture et la fermeture de la connexion entre ledit dispositif pilote sans fil (10) et ledit au moins un conducteur électrique (13, 14) dudit système électrique (15).

3. Groupe de commande pour une charge électrique (11) selon l'une quelconque des revendications précédentes, **caractérisé en ce que** ledit dispositif (10) de commande sans fil comprend un élément capacitif adapté pour maintenir ledit circuit d'alimentation électrique (20) alimenté pour la durée (To) dudit signal de commande manuelle.

4. Groupe de commande pour une charge électrique (11) selon l'une quelconque des revendications précédentes, **caractérisé en ce que** lesdits premiers moyens de commutation (21) sont connectés en parallèle avec un variateur retardé (22).

5. Procédé de commande d'une charge électrique (11) alimentée par le biais d'un système électrique (15) comprenant les étapes de détection (110) de la présence d'un signal de commande sans fil ou d'un signal de commande manuelle entrant dans un dispositif (10) de commande de ladite charge (11), et de commutation (120) de l'état de ladite charge (11) dans le cas où au moins un entre ledit signal de commande sans fil et ledit signal de commande manuelle est détecté, **caractérisé en ce que** ledit signal de commande manuelle est un signal d'absence de tension ayant une durée (To) comprise entre une valeur minimale (Tₘᵢₙ) et une valeur maximale (Tₘₐₓ), ledit dispositif de commande (10) étant réinitialisé si ladite durée (To) dudit signal de commande manuelle d'absence de tension est plus longue que ladite valeur maximale (Tₘₐₓ).

6. Procédé de commande d'une charge électrique (11) selon la revendication 5, **caractérisé en ce qu'**il comprend une étape de détection (150) et de stockage (160) d'une variation de la puissance absorbée par ladite charge (11) à la suite de la détection d'un signal de commande manuelle, et une étape d'alimentation de ladite charge avec ladite puissance modifiée.
